# EUROPÄISCHE PATENTSCHRIFT

(11) **EP 3 321 707 B1**
(45) Veröffentlichungstag und Bekanntmachung des Hinweises auf die Patenterteilung: **01.01.2020**
(21) Anmeldenummer: 17200488.9
(22) Anmeldetag: 08.11.2017
(51) Int. Cl.: G01R 33/30, G01N 24/08, G01R 33/31

(54) **ÜBERWACHUNGSEINRICHTUNG ZUR KONTROLLE VON CHEMISCHEN REAKTIONEN MITTELS MR-MESSUNGEN IN EINER DURCHFLUSSZELLE**
MONITORING DEVICE FOR MONITORING CHEMICAL REACTIONS USING MR MEASUREMENTS IN A FLOW-THROUGH CELL
DISPOSITIF DE SURVEILLANCE DESTINÉ À CONTRÔLER DES RÉACTIONS CHIMIQUES AU MOYEN DE MESURES PAR RM DANS UNE CELLULE D'ÉCOULEMENT

(30) Priorität: 15.11.2016 DE 102016222363
(43) Veröffentlichungstag der Anmeldung: 16.05.2018
(73) Patentinhaber: Bruker BioSpin GmbH, 76287 Rheinstetten (DE)
(72) Erfinder: BRAUMANN, Ernst Ulrich, 76275 Ettlingen (DE); HOFMANN, Martin, 76332 Bad Herrenalb (DE)
(74) Vertreter: Kohler Schmid Möbus Patentanwälte

(56) Entgegenhaltungen:
- DAVID A. FOLEY ET AL: "NMR Flow Tube for Online NMR Reaction Monitoring", ANALYTICAL CHEMISTRY, Bd. 86, Nr. 24, 3. Dezember 2014 (2014-12-03), Seiten 12008-12013, XP055458030, US ISSN: 0003-2700, DOI: 10.1021/ac502300q
- MAIWALD M ET AL: "Quantitative high-resolution on-line NMR spectroscopy in reaction and process monitoring", JOURNAL OF MAGNETIC RESONANCE, ACADEMIC PRESS, ORLANDO, FL, US, Bd. 166, Nr. 2, Februar 2004 (2004-02), Seiten 135-146, XP004483621, ISSN: 1090-7807, DOI: 10.1016/J.JMR.2003.09.003

## Beschreibung

Die Erfindung betrifft eine Überwachungseinrichtung zum Durchführen einer analytischen Messung an einer in einem Reaktionsbehälter erzeugten Reaktionsflüssigkeit im Spektrometer, wobei die Überwachungs-einrichtung folgende Baugruppen aufweist:
eine im Spektrometer anzuordnende Überwachungszelle zur Aufnahme der im Spektrometer zu vermessenden Reaktionsflüssigkeit sowie zu deren Rücktransport zum Reaktionsbehälter;
eine Verteilereinrichtung zur Verteilung von Reaktionsflüssigkeit zwischen der Überwachungszelle und dem Reaktionsbehälter, in welche mindestens zwei Leitungen zur Zuführung von Reaktionsflüssigkeit vom Reaktionsbehälter zur Verteilereinrichtung und zu deren Rückführung von der Verteilereinrichtung zum Reaktionsbehälter sowie mindestens zwei weitere Leitungen zur Zuführung von Reaktionsflüssigkeit von der Verteilereinrichtung zur Überwachungszelle und zu deren Rückführung von der Überwachungszelle zur Verteilereinrichtung münden, wobei die Verteilereinrichtung eine Verteiler-Vorrichtung zur Verteilung von Reaktionsflüssigkeit auf die mindestens vier in die Verteilereinrichtung mündenden Zuführ- und Rückführ-Leitungen umfasst.

Eine solche Überwachungseinrichtung mit einer als NMR-Durchflusszelle ausgestalteten Überwachungszelle ist etwa aus dem Artikel "Enhancing Reaction Understanding with Online NMR Reaction Monitoring - Application to Chemical Route Development" von Anna L. Dunn, Anna Codina, David A. Foley und Mark T. Zell bekannt geworden, wie er im November 2016 auf der Internetseite der Anmelderin unter <https://www.bruker.com/fileadmin/user_upload/8-PDF-Docs/MagneticResonance/NMR/brochures/T158434_EnhancingReactionMonit oring.pdf> publiziert war.

Ebenso gibt der ebenda publizierte Vortrag von Anna Codina mit dem Titel "Insight NMR - Hardware and Software for Reaction Monitoring", der von der Autorin auf der internationalen Konferenz SMASH 2015 in Baveno, Italien, gehalten wurde, Einblicke in den technischen Aufbau und die Funktionsweise einer derartigen Überwachungseinrichtung. Auch wird das zugehörige Produkt *"InsightMR Flow Unit"* von der Anmelderin unterdessen kommerziell vertrieben.

Der Artikel von David A. Foley ET AL: "NMR Flow Tube for Online NMR Reaction Monitoring", Analytical Chemistry, Bd. 86, Nr. 24, 3. Dezember 2014 (2014-12-03), Seiten 12008-12013, XP055458030, US ISSN: 0003-2700, D01: 10.1021/ac502300q beschreibt ebenfalls eine Überwachungseinrichtung der eingangs definierten Art, die zudem über eine Pumpe verfügt.

### Hintergrund der Erfindung

Die vorliegende Erfindung betrifft allgemein den Bereich der kontinuierlichen Überwachung chemischer Reaktionen mittels einer analytischen Messung, vorzugsweise mittels der Magnetresonanz-Spektroskopie.

Insbesondere die NMR(=Nuclear Magnetic Resonance)-Spektroskopie ist eine weit verbreitete Messmethode, mit der chemische Verbindungen analysiert werden können. Üblicherweise wird bei der NMR-Spektroskopie eine zu vermessende Probe in einem Probenröhrchen in eine Probensonde gegeben, welche im NMR-Spektrometer vermessen wird.

Bei der chemischen Reaktionskontrolle geht es im Wesentlichen um die Optimierung von Reaktionsparametern (Temperatur, Druck, Lösemittel, Katalysator,...) mit dem Zweck, das Reaktionsgleichgewicht auf die Produktseite zu verschieben und/oder Fehlreaktionen zu unterdrücken. Um eine permanente Reaktionskontrolle mittels NMR-Spektroskopie zu erhalten müssten somit regelmäßig Proben entnommen werden, was einen großen Aufwand bedeuten würde.

Beim Probentransfer sollten die Reaktionsbedingungen (z.B. Temperatur & Druck) eingehalten werden, damit sich die zu vermessende Probe nicht verändert. Auch spielt der Zeitfaktor zwischen der Probenentnahme und der (NMR) Messung eine erhebliche Rolle.

Da das NMR-Spektrometer und der chemische Reaktor zwangsläufig räumlich getrennt sind, wird bei der Reaktionskontrolle in einem geschlossenen System das Reaktionsgemisch kontinuierlich aus dem Reaktor in die Probensonde gepumpt, wo es in regelmäßigen Abständen vermessen wird. Hierbei sollten in dem Transportsystem möglichst analoge Bedingungen wie in dem Reaktionsgefäß herrschen. Dies betrifft insbesondere die Reaktionstemperatur.

In der US 8,686,729 B2 beziehungsweise in der parallelen EP 2 407 796 B1 ist jeweils eine Durchflusszelle für eine chemische Reaktionskontrolle mittels NMR-Spektroskopie beschrieben (Prinzip "Fast-Loop" & "Slow-Loop"). Mit der bekannten Vorrichtung wird kontinuierlich das flüssige Reaktionsgemisch von dem Reaktor bis zur NMR-Probensonde im Messgerät gepumpt, wo die Flüssigkeit vermessen wird. Das bekannte System funktioniert mit insgesamt vier-koaxial ineinander liegenden- Schläuchen, wobei die inneren beiden Kapillaren die Transportkapillaren bilden für das Reaktionsgemisch. Die beiden äußeren Schläuche dienen der Zirkulation einer Temperierflüssigkeit. Um die vier koaxialen Leitungen mit den jeweiligen Zu- und Rückleitungen zu verbinden, bedarf es mehrerer Verbindungsstellen, was zu einer großen Komplexität des Systems führt.

Bei diesem Stand der Technik (NMR Flow Cell gemäß EP 2 407 796 B1) wird ein manuell justierbares Reduzierventil (Split-Funktion) eingesetzt, um die Flussmenge in der "Slow-Loop" einzustellen. Da weder eine Skalierung über die Stellung des Ventils existiert noch gar eine aktive Messung des tatsächlichen Split-Fluss-Verhältnis zwischen "Fast-Loop" & "Slow-Loop" vorgesehen ist, ist man bei einem solchen System entweder auf grobe Schätzungen bzw. langwierige Testmessungen zur Kalibrierung angewiesen. Veränderte System-Bedingungen werden immer einen entscheidenden Einfluss auf das Split-Verhältnis nach sich ziehen und eine erneute Kalibrierung unter den neuen Bedingungen erforderlich machen. Da sich bei Reaktionen die Bedingungen aber in der Regel per se ändern, ist somit eine genaue Angabe des Split-Verhältnisses nur sehr unzureichend bzw. überhaupt nicht möglich.

Eine verbesserte, als NMR-Durchflusszelle ausgestaltete Überwachungszelle ist in der DE 10 2015 206 030 B3 gezeigt. Diese wird auch bei dem eingangs zitierten, von der Anmelderin angebotenen Produkten eingesetzt und hat unter anderem die Vorteile, dass in den Zu- und Rückleitungen der flüssigen Mess-Probe zwischen der Überwachungszelle und der Verteilereinrichtung eine gleichmäßige Temperatur beibehalten werden kann, um das thermische Gleichgewicht nicht zu beeinflussen. Das System für die Probenentnahme ist dabei derart einfach aufgebaut, dass es mit wenigen genormten und im Handel ohne Weiteres erhältlichen Verbindungs- oder Anschlussstellen auskommt, wobei bereits vorhandene Einrichtungen leicht nachrüstbar sein sind.

Nachteilig bei allen bisher bekannten gattungsgemäßen Überwachungseinrichtungen sind jedoch folgende Punkte:
Eine Automatisierung des experimentellen Ablaufs ist derzeit bei keiner bekannten Anordnung möglich. Insbesondere besteht die Verteiler-Vorrichtung zur Verteilung von Reaktionsflüssigkeit üblicherweise aus einem simplen Handventil, welches den Eingriff einer Bedienungsperson unerlässlich macht. Insbesondere eine -etwa computergesteuerte- Regelung des Reaktions- und/oder Mess-Prozesses oder gar ausgesuchter Prozessparameter ist damit im Stand der Technik ausgeschlossen. Es besteht daher aktuell keine, auf gar keinen Fall jedoch eine volle System-Kontrolle. Weder Pumpen noch Ventile noch die Temperatur können den geforderten Bedingungen angepasst werden, jedenfalls nicht ohne einen jeweils manuellen Eingriff. Insbesondere, wenn während einer Reaktion Temperaturbedingungen automatisch angepasst/geändert oder aufgrund des vom Spektrometer aktuell gelieferten Ergebnisses die Reaktionen gestoppt bzw. angepasst werden müssten/sollten, ist dies derzeit wegen fehlender Status-Rückmeldungen gar nicht möglich. Wie schon in DE 10 2015 206 030 B3 beschrieben, gibt es viele Verbindungsstellen, welche potentielle Gefahrenquellen für Undichtigkeit bilden können. Diese sollten aber -trotz der steigenden Komplexität- auf ein Minimum reduziert werden. Außerdem ist bei der bekannten Anordnung die Transfer-Kapillare mit 4m - 7m, je nach Feldstärke des Magneten, relativ lang. Damit sind auch interne Volumina sowie auch die Transferzeit unnötig groß. Bei Reaktionen, die im Minutenbereich ablaufen, kann dies aber bereits zu ungewünschten Änderungen führen.

Schließlich ist bei keiner der bekannten gattungsgemäßen Überwachungseinrichtungen der gesamte Strömungspfad der Reaktionsflüssigkeit temperierbar, sondern bestenfalls Abschnitte desselben. Auch ist eine Temperierung der Verteilereinrichtung selbst weder vorgesehen noch bei den bekannten Anordnung überhaupt möglich. Es gibt aktuell weder Temperaturnoch Druck-Sensoren um die Betriebssicherheit zu gewährleisten.

### Aufgabe der Erfindung

Demgegenüber liegt der vorliegenden Erfindung die -im Detail betrachtet relativ anspruchsvolle und komplexe- Aufgabe zugrunde, bei einer Überwachungseinrichtung der eingangs beschriebenen Art mit unaufwändigen, einfach beschaffbaren technischen Mitteln eine überwiegend automatisierte und auch hinsichtlich ausgesuchter Prozessparameter gezielt optimierbare Reaktions-kontrolle zu ermöglichen, wobei eine Probe aus dem Reaktionsbehälter zeitnah zum Ablauf der chemischen Reaktion für analytische Messungen im Spektrometer zur Verfügung gestellt werden soll, die Messung (im Fluss oder gestoppt) gestartet und anhand des aktuellen Messergebnisses gegebenenfalls weitere Schritte zur Steuerung der chemischen Reaktion zeitnah veranlasst werden können. Diese Schritte können etwa weitere Dosierschritte, eine Modifikation des Reaktionsablaufs oder auch einfach nur das Beenden der Reaktion einleiten. Der Vorgang sollte softwaregesteuert, automatisiert und in hohem Maße reproduzierbar gestaltet werden können. Schließlich sollte eine Möglichkeit der Temperatur-Kontrolle geschaffen werden, die vorzugsweise den gesamten Flusspfad der entnommenen Reaktionsflüssigkeit einschließlich der am Prozess beteiligten Pumpen sowie wesentlicher Bestandteile der Verteilereinrichtung einschließt, wobei die Überwachungseinrichtung räumlich möglichst kompakt aufgebaut sein sollte.

### Kurze Beschreibung der Erfindung

Diese Aufgabe wird durch die vorliegende Erfindung auf ebenso überraschend einfache wie wirkungsvolle Weise dadurch gelöst, dass die Verteilereinrichtung einen Verteiler-Behälter aufweist ,in welchem die Verteiler-Vorrichtung sowie eine elektrisch ansteuerbare Pumpeinrichtung zum Pumpen von Reaktionsflüssigkeit angeordnet sind, dass die Verteiler-Vorrichtung eine elektrisch ansteuerbare Ventileinrichtung zur Verteilung von Reaktionsflüssigkeit auf die mindestens vier in den Verteiler-Behälter mündenden Zuführ- und Rückführ-Leitungen umfasst, dass eine Steuer- und Regelvorrichtung zur elektrischen Ansteuerung der Pumpeinrichtung sowie zur elektrischen Ansteuerung der Ventileinrichtung vorhanden ist, und dass die elektrisch ansteuerbare Ventileinrichtung zur Verteilung von Reaktionsflüssigkeit ein umschaltbares Vier-Wege-Ventil umfasst, welches in einer ersten Betriebsstellung ("on flow") die Zuführ-Leitung vom Reaktionsbehälter zum Verteiler-Behälter -direkt oder indirekt- mit der Zuführ-Leitung vom Verteiler-Behälter zur Überwachungszelle sowie die Rückführ-Leitung von der Überwachungszelle zum Verteiler-Behälter -direkt oder indirekt- mit der Rückführ-Leitung vom Verteiler-Behälter zum Reaktionsbehälter verbinden kann, und welches in einer zweiten Betriebsstellung ("stopped flow") die Zuführ-Leitung vom Reaktionsbehälter zum Verteiler-Behälter -direkt oder indirekt- mit der Rückführ-Leitung vom Verteiler-Behälter zum Reaktionsbehälter sowie die Zuführ-Leitung vom Verteiler-Behälter zur Überwachungszelle -direkt oder indirekt- mit der Rückführ-Leitung von der Überwachungszelle zum Verteiler-Behälter verbinden kann.

Mit der vorliegenden Erfindung werden insbesondere folgende Vorteile erzielt:
Die erfindungsgemäße Unterbringung der Verteilereinrichtung in einem gemeinsamen Verteiler-Behälter macht das System einerseits besonders kompakt und platzsparend, andererseits ermöglicht diese Anordnung überhaupt erst eine möglichst weitgehende Temperierung und letzten Endes eine Temperaturkontrolle der zentralen Systembestandteile. Ansonsten müsste man hierfür nämlich sämtliche Kapillaren, Leitungen, Anschlüsse und Ventile, die beweglich sind, sowie auch die Pumpe(n) jeweils einzeln und für sich temperaturisolieren, wenn diese nicht in einem gemeinsamen Behälter untergebracht sind. Ein weiterer Vorteil ergibt sich aus der kompakten Bauweise, insbesondere auch im Hinblick auf die Stromversorgung, die nunmehr mit nur einem einzigen Netzteil für Pumpen und elektrische Ventile auskommt. Außerdem eröffnet die erfindungsgemäße Lösung -im Gegensatz zu den bisher übliche "dezentralen" Anordnungen auch die Möglichkeit, eine solche kompakte Box insgesamt in der räumlichen Nähe des Spektrometers zu positionieren, was die weiter unten beschriebenen zusätzlichen Vorteile bringt.

Die geforderte elektrische Ansteuerbarkeit der Ventileinrichtung zur Verteilung von Reaktionsflüssigkeit ist ein wesentlicher Schritt weg von einer manuellen Bedienung der Apparatur und hin zu einem automatisierbaren Ablauf des Messprozesses sowie zu einer -wiederum automatisierbaren- aktiven Beeinflussung der Bedingungen der überwachten Reaktion in Abhängigkeit von festlegbaren Rahmenwerten und ausgewählten Parametern. Letztere können -wie unten näher erläutert wird- durch die Anbringung von Sensoren und Detektoren in Echtzeit beobachtet und dadurch in eine aktive Prozess-Steuerung und sogar -Regelung eingebracht werden. Die hierdurch gewonnenen komplexen Informationen über den Prozess-Ablauf können aber auch anderweitig verwertet werden.

Die eigentliche Automatisierung sowie eine Steuerung und Regelung ermöglicht dann vollends die erfindungsgemäß vorgesehene Steuer- und Regelvorrichtung zur elektrischen Ansteuerung der Pumpeinrichtung sowie zur elektrischen Ansteuerung der Ventileinrichtung.

Die Steuerung und Regelung erhöht wesentlich die Betriebssicherheit für Anwender, Gerätschaften und Umwelt. Durch das Auslesen der Sensoren und Verarbeiten der Werte können mit geeigneter Software sicherheitsrelevante Aspekte berücksichtigt und entsprechend reagiert werden um Schaden jeglicher Art zu vermeiden.

Durch das Auslesen der Sensoren und Verarbeiten der Werte können mit einer geeigneten Software und der entsprechenden Reaktion auch eine höhere Reproduzierbarkeit und Vergleichbarkeit der Messdaten erreicht werden.

Mit einem 4-Wege 2Pos.2L Ventil können verschiedene Analysebedingungen abgedeckt werden: In "On-Flow" Stellung können besonders zeitnah Reaktionsveränderungen gemessen werden, welche im Reaktor durch Zugabe von Reaktant, beziehungsweise Änderungen der Reaktionsbedingungen, wie z.B. Temperaturreduktion oder-erhöhung, beeinflusst werden.
In der "Stopped-Flow" Stellung kann der Reaktionsverlauf (=Kinetik) einer sich nicht bewegender Probe vermessen werden. Das ist bei langsamen Reaktionen, die über Minuten oder Stunden ablaufen, von großem Vorteil. Diese Messungen sind wesentlich stabiler, da sich die Probe nicht bewegt.

In den Rahmen der vorliegenden Erfindung fällt auch eine Überwachungseinrichtung für ein System der oben beschriebenen erfindungsgemäßen Art.

### Bevorzugte Ausführungsformen und Weiterbildungen der Erfindung

Eine erste Klasse von vorteilhaften Ausführungsformen ist dadurch gekennzeichnet, dass die elektrisch ansteuerbare Pumpeinrichtung zum Pumpen von Reaktionsflüssigkeit nur eine einzige Pumpe umfasst. Ein solches besonders einfaches System kann kostengünstiger angeboten werden. Es sind zwar ebenfalls "On-Flow" & Stopped-Flow" Modi möglich, allerdings wird die Transferzeit vom Reaktor zu der Überwachungszelle wesentlich länger dauern, da man in diesem Fall die Flussraten der Pumpe nicht beliebig hoch einstellen kann (höhere Flüsse resultieren in hohem Systemdruck, schlechteres Messergebnis im Magneten). Bei Flüssen ab 3ml/min ist bereits eine deutliche NMR-Signal-Reduktion sichtbar. Somit können mit diesem System nur Reaktionen sinnvoll untersucht werden die sich in einem Bereich ab mehreren Minuten liegen. Das System unterliegt daher gewissen Einschränkungen.

Alternativ umfasst bei einer weiteren Klasse von Ausführungsformen die elektrisch ansteuerbare Pumpeinrichtung zum Pumpen von Reaktionsflüssigkeit eine Transportpfad-Pumpe, welche Reaktionsflüssigkeit aus der Zuführ-Leitung vom Reaktionsbehälter zum Verteiler-Behälter zur Rückführ-Leitung vom Verteiler-Behälter zum Reaktionsbehälter pumpen kann, und die Pumpeinrichtung umfasst zusätzlich eine Messpfad-Pumpe, welche zumindest einen Teilstrom der von der Transportpfad-Pumpe geförderten Reaktionsflüssigkeit in die Ventileinrichtung zur Verteilung von Reaktionsflüssigkeit auf die mindestens vier in den Verteiler-Behälter mündenden Zuführ- und Rückführ-Leitungen pumpen kann.

Durch ein solches Zwei-Pumpensystem wird die Transferzeit vom Reaktor zu der Überwachungszelle wesentlich verkürzt, da man in diesem Fall die Flussrate der Transportpfad Pumpe (beliebig) hoch einstellen kann. 15ml/min und mehr werden möglich sein. Die Zirkulationsdauer der Probe vom Reaktor zur Pumpe und zurück beträgt lediglich ein paar Sekunden. Systemdruck, Messergebnis im Magneten werden dadurch nicht beeinflusst. Die Messpfad-Pumpe, die sich nahe an der Überwachungszelle befindet, entnimmt aus dem Transportpfad ein gewisses Proben-Volumen bzw. fördert permanent mit angepasster geringer Flussrate die Probe zur Überwachungszelle. Bei Flüssen kleiner 3ml/min ist nahezu keine NMR-Signal-Reduktion sichtbar. Da das interne Volumen in dem Messpfad wesentlich geringer ist als in dem Transportpfad, ergibt sich ein Messergebnis das wesentlich näher an dem Zeitpunkt der Reaktion im Reaktionsbehälter liegt, als bei der oben beschriebenen einfacheren Version mit nur einer Pumpe. Somit können mit diesem System auch Reaktionen untersucht werden die in einem Bereich von <1 Minute liegen.

Besonders bevorzugt sind Weiterbildungen dieser Klasse von Ausführungsformen, bei denen im Strömungspfad der geförderten Reaktionsflüssigkeit nach der Transportpfad-Pumpe ein erstes Verteilerstück, insbesondere ein erstes T-Stück, angeordnet ist, welches einen Teilstrom der von der Transportpfad-Pumpe geförderten Reaktionsflüssigkeit zur Messpfad-Pumpe und einen weiteren Teilstrom zur Rückführ-Leitung vom Verteiler-Behälter zum Reaktionsbehälter umleitet, und wobei im Strömungspfad der geförderten Reaktionsflüssigkeit vor der Rückführ-Leitung vom Verteiler-Behälter zum Reaktionsbehälter ein weiteres Verteilerstück, insbesondere ein weiteres T-Stück, angeordnet ist, welches den Teilstrom der von der Transportpfad-Pumpe zur Rückführ-Leitung vom Verteiler-Behälter zum Reaktionsbehälter geförderten Reaktionsflüssigkeit sowie einen Teilstrom von aus der Ventileinrichtung austretenden Reaktionsflüssigkeit zusammenfasst und zur Rückführ-Leitung vom Verteiler-Behälter zum Reaktionsbehälter umleitet.

Ein T-Stück ist die einfachste Form eines Verteilers. Man könnte hier auch ein 3-Wege- 2Pos-1L Ventil .einsetzen, was aber eines zusätzlichen Steuerungs- und Mechanik-Aufwandes bedürfte ohne einen wesentlichen Mehrwert zu bewirken.

Weitere vorteilhafte Ausführungsformen sind dadurch gekennzeichnet, dass die mit Reaktionsflüssigkeit benetzten Teile der Pumpeinrichtung und der Ventileinrichtung sowie der gesamte Flüssigkeitspfad der Reaktionsflüssigkeit aus chemisch inerten Materialien aufgebaut sind, insbesondere Glas, PTFE (=Polytetrafluorethylen), PCTFE (=Polychlortrifluorethylen), ETFE (=Ethylentetrafluorethylen).

Der Hersteller eines solchen Systems weiß im Vorfeld nicht, welche Reaktionen in der Anordnung bei seinen Kunden ablaufen werden. Er möchte aber ein möglichst großes Feld an Applikationen abdecken. Diese können wässriger Natur sein, bei denen z.B. lebende Organismen untersucht werden, aber auch Reaktionen unter extremen pH-Werten. Sie können unter extremen Temperaturbedingungen ablaufen bzw. es werden radikale, korrosive Reagenzien wie z.B. FCKW oder andere organische Lösemittel eingesetzt welche mit vielen Kunststoffen und Metallen reagieren. Daher sollten Materialien für den benetzten Kontakt-Bereich gewählt werden, die gegen möglichst viele im Labor eingesetzten Chemikalien eine Resistenz zeigen.

Eine weitere bevorzugte Ausführungsform der erfindungsgemäßen Überwachungseinrichtung zeichnet sich dadurch aus, dass die Pumpeinrichtung und die Ventileinrichtung sowie der gesamte Flüssigkeitspfad der Reaktionsflüssigkeit aus Materialien aufgebaut sind, die in einem Betriebs-Temperaturbereich von -50°C bis +150°C, vorzugsweise von -20°C bis +100°C, einsetzbar sind. Dies ermöglicht einen praktischen Einsatz der Erfindung in nahezu allen denkbaren Anwendungsfällen.

Besonders bevorzugt sind Weiterbildungen der oben beschriebenen zweiten Klasse von Ausführungsformen, bei denen zumindest eine Pumpe der elektrisch ansteuerbaren Pumpeinrichtung zum Pumpen von Reaktionsflüssigkeit, vorzugsweise die Transportpfad-Pumpe, derart ausgelegt ist, dass sie mit einer Flussrate von 10 bis 1000ml/min betrieben werden kann.

Die Transportpfad-Pumpe kann damit eine hohe Flussrate (> 20ml/min) fahren, wodurch eine schnellere Zirkulation zwischen Reaktor Pumpe Reaktor ermöglicht wird.

Vorteilhaft sind auch Weiterbildungen der oben beschriebenen zweiten Klasse von Ausführungsformen, bei denen zumindest eine Pumpe der elektrisch ansteuerbaren Pumpeinrichtung zum Pumpen von Reaktionsflüssigkeit, vorzugsweise die Messpfad-Pumpe, derart ausgelegt ist, dass sie mit einer Flussrate von 0,1 bis 10ml/min betrieben werden kann.

Die Messpfad-Pumpe kann mithin eine niedrige Flussrate fahren (<1ml/min). Damit werden exakte Entnahmevolumen und bessere MR-Messbedingungen im "On-Flow" Modus ermöglicht.

Ganz besonders bevorzugt sind Ausführungsformen der Erfindung, bei denen die Steuer- und Regelvorrichtung zur elektrischen Ansteuerung der Pumpeinrichtung sowie zur elektrischen Ansteuerung der Ventileinrichtung derart ausgestaltet ist, dass sie eine unabhängige Fluss- und Volumensteuerung, insbesondere eine unabhängige Ansteuerung der Transportpfad-Pumpe und der Messpfad-Pumpe, in Abhängigkeit vom Reaktionsverlauf im Reaktionsbehälter ermöglicht.

Beim derzeitigen Stand der Technik sind alle in dem System befindlichen Module eigenständig und nur separat steuerbar. Es besteht keine Kommunikation zwischen den einzelnen Objekten (Reaktor, Thermostat; Pumpe(n) Ventil, Spektrometer).welche nur annähernd ein Automation ermöglichen. Es gibt keine reaktionsabhängige Aktionen die den Transfer der Probe und Start/Stopp der Messung automatisch einleiten. Da aber eine Reaktion dynamisch ist und man ggf. auf Reaktionsabläufe reagieren muss/will, ist eine Kommunikation und aktive Steuerung unabdingbar. Dies gilt nicht nur für eine Reaktion im Reaktionsgefäß und in der Überwachungszelle, sondern auch für Bedingungen innerhalb des Systems. So müssen an verschiedenen ausgewählten Stellen Druck (Verstopfung oder Leckage), Temperatur (min °C, max °C) und pH Wert gemessen werden, damit man im Bedarfsfall entgegensteuern kann. Um dies zu ermöglichen werden Sensoren an ausgewählten Stellen platziert, die Druck, Temperatur und pH überwachen.

Ebenso bevorzugt sind Ausführungsformen der erfindungsgemäßen Überwachungseinrichtung, bei welchen die Steuer- und Regelvorrichtung zur elektrischen Ansteuerung der Pumpeinrichtung sowie zur elektrischen Ansteuerung der Ventileinrichtung derart ausgestaltet ist, dass sie eine Zeit-gesteuerte und/oder eine Volumen-gesteuerte Regelung der Ventileinrichtung und/oder der Pumpeinrichtung in Abhängigkeit vom Reaktionsverlauf im Reaktionsbehälter ermöglicht.

Eine Volumensteuerung ermöglicht die Entnahme eines bestimmten Volumens, welche die Probe in der Überwachungszelle austauscht und zu erneuten Messung im Spektrometer zur Verfügung stellt. Dies wiederum ermöglicht eine schnelle minimierte zur Verfügungsstellung der Probe in der Überwachungszelle. Eine Zeitsteuerung erlaubt ein regelmäßige Entnahme der Probe aus dem Transportpfad bzw. Reaktor alle nn Zeitintervalle, um den Ablauf von langsamen Reaktionen mit reduzierten Messungen zu verfolgen. Damit kann z.B. alle 5 Minuten eine Messung des aktuellen Reaktionsstand durchgeführt werden, bis sich keine Änderungen mehr zeigen und man die Reaktion als vollständig umgesetzt erkennt und daher beenden kann.

Weitere, ganz besonders vorteilhafte Ausführungsformen der Erfindung sind dadurch gekennzeichnet, dass der Verteiler-Behälter von einem Gehäuse umgeben ist, welches thermisch isolierend aufgebaut ist.

Manche chemischen Reaktionen sind nämlich sehr temperaturempfindlich. Bei falscher Temperatur im System könnten Reaktionen langsamer als erforderlich ablaufen, stoppen bzw. schneller als gewünscht voranschreiten, oder Bei-Produkte fallen aus und verstopfen den Transfer- bzw. Messpfad. Um Kälte- bzw. Wärmebrücken zu vermeiden und möglichst wenig Verluste in der Temperierung des Systems zu erhalten, sollten daher alle von der Probe durchflossenen Teile entsprechend isoliert sein.
Es wäre baulich sehr aufwändig, die Kapillaren und deren Anschlüsse an die Ventile, sowie die Ventile selbst und die Pumpenköpfe (nicht die Motoren) getrennt zu isolieren. Vom Aufbau ist es wesentlich praktischer, die gesamte Apparatur (Verteiler-Vorrichtung) in einem Gehäuse anzuordnen und als Gesamtraum zu temperieren.

Bei einer weiteren Klasse von besonders bevorzugten Ausführungsformen der erfindungsgemäßen Überwachungseinrichtung ist daher zudem eine Thermostat-Einrichtung vorhanden, mittels welcher der gesamte Flusspfad der geförderten Reaktionsflüssigkeit vom Reaktionsbehälter über den Verteiler-Behälter zur Überwachungszelle und zurück einer Temperaturkontrolle, insbesondere einer aktiven Temperaturregelung, unterzogen werden kann.

Besonders bevorzugt sind Weiterbildungen dieser Klasse von Ausführungsformen, bei denen die Steuer- und Regelvorrichtung zur elektrischen Ansteuerung der Pumpeinrichtung sowie zur elektrischen Ansteuerung der Ventileinrichtung derart ausgestaltet ist, dass sie eine Temperatursteuerung der Thermostat-Einrichtung in Abhängigkeit vom Reaktionsverlauf im Reaktionsbehälter ermöglicht.

Weitere vorteilhafte Ausführungsformen sind dadurch gekennzeichnet, dass der Verteiler-Behälter räumlicher näher zur Überwachungszelle als zum Reaktionsbehälter angeordnet ist, wobei insbesondere die Distanz zwischen Verteiler-Behälter und Reaktionsbehälter doppelt, vorzugsweise dreimal, insbesondere sechsmal, so groß ist wie die Distanz zwischen Verteiler-Behälter und Überwachungszelle.

Die Positionierung der Überwachungseinrichtung sollte immer derart gewählt werden, dass sie sich so nah wie möglich am Messplatz (Spektrometer) befindet. Bei MR-Systemen mit kleinen Magneten kann das Verhältnis (Distanz Reaktor zu Verteilerbehälter : Verteilerbehälter zu Überwachungszelle) etwa 3:1 betragen. Bei Hochfeldmagneten (<600MHz) kann es aber auch 6:1 sein.

Die Sensorik ist in der Regel ein wichtiger Bestandteil einer erfindungsgemäßen Überwachungseinrichtung im Sinne einer Automation sowie ausreichender Betriebssicherheit: Ihre Aufgabe ist es, das System zu überwachen und auf Reaktionsabläufe reagieren. Diese Abhängigkeiten und die stets präsente Aufgabe, die Sicherheit des Systems zu erhöhen/zu garantieren, werden in der Regel den Einsatz von -vielfältig ausgestaltbaren- Sensoren zur Überwachung der Reaktion und Erhöhung der Betriebssicherheit des Systems erforderlich machen.

Derartige Sensoren sollten bei einer erfindungsgemäßen Überwachungs-einrichtung unter anderem eingesetzt werden,
... um eine Kommunikation zur automatisierten MR-Messung (Start/Stopp) in Abhängigkeit zum Reaktionsverlauf zu ermöglichen;
... um eine Temperatursteuerung des Thermostaten zu ermöglichen;
... um aktuelle IST-Werte für eine Temperaturüberwachung im System auslesen zu können und entsprechende Aktionen an den Thermostaten zur Regelung zu ermöglichen;
... um aktuelle IST-Werte für eine interne Drucküberwachung der unterschiedlichen Kreisläufe auslesen zu können und entsprechende Aktionen an die Pumpen zur Regelung der Flussraten zu ermöglichen, welche der erhöhten Sicherheit dienen, bis hin zu einem automatischen Not-Aus.

So sollten etwa pH-Sensoren im Reaktor platziert sein, Temperatur-Sensoren im Reaktor, in der Verteiler-Vorrichtung, im Thermostaten, im Spektrometer, Druck-Sensoren nach der Pumpe im Transportpfad, nach der Pumpe im Messpfad, und so weiter.

Wünschenswert kann auch der Einsatz von weiteren Sensoren wie etwa IR-Sensoren, Raman-Sensoren, UV-Sensoren, etc. sein, die als zusätzliche Informationsquellen ebenfalls denkbar sind.

In den Rahmen der vorliegenden Erfindung fällt auch die Verwendung eines Systems mit den oben beschriebenen erfindungsgemäßen Merkmalen zur Reaktionskontrolle einer chemischen Reaktion mittels NMR-Spektroskopie.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1a: eine schematische Darstellung einer einfachen Ausführungsform der erfindungsgemäßen Überwachungseinrichtung mit nur einer Pumpe und ohne Temperier-Einrichtung in der "On-Flow"-Position;
- Fig. 1b: das System nach Fig. 1a in der "Stopped-Flow"-Position;
- Fig. 2a: eine schematische Darstellung einer Ausführungsform der erfindungsgemäßen Überwachungseinrichtung mit zwei Pumpen (wiederum dargestellt ohne Temperier-Einrichtung) in der "On-Flow"-Position;
- Fig. 2b: das System nach Fig. 2a in der "Stopped-Flow"-Position;
- Fig. 3: eine schematische Darstellung der Ausführungsform nach Fig. 2a, aber mit Temperier-Einrichtung und thermischer Isolation des gesamten Flusspfads der geförderten Reaktionsflüssigkeit vom Reaktionsbehälter über den Verteiler-Behälter zur Überwachungszelle sowie zurück; und
- Fig. 4: eine schematische Darstellung einer Überwachungseinrichtung nach dem Stand der Technik.

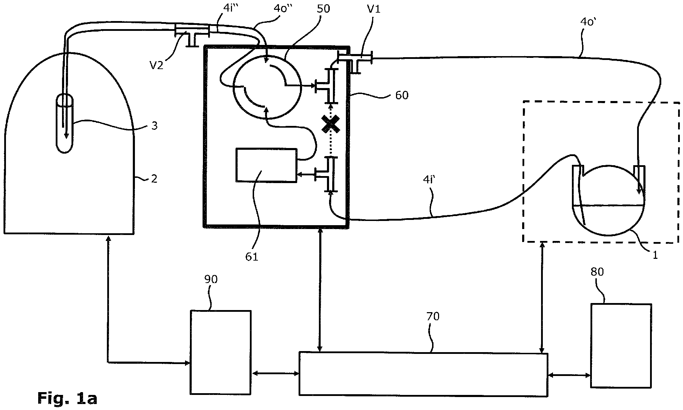

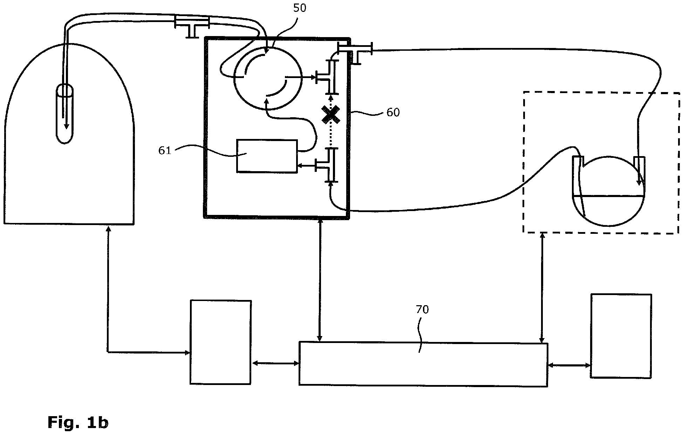

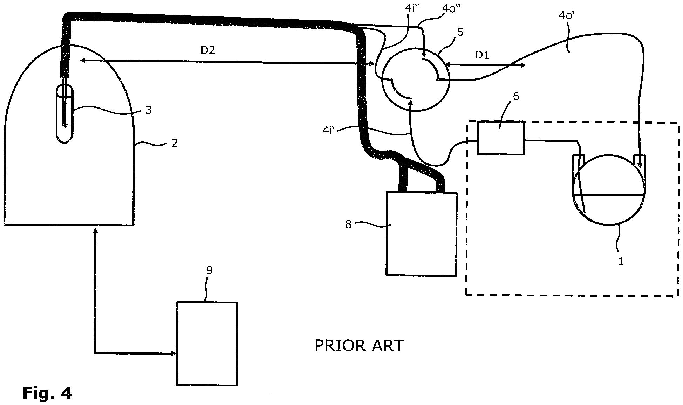

Die Figuren 1a bis 3 der Zeichnung zeigen jeweils in einer schematischen Ansicht eine bevorzugte Ausführungsform der erfindungsgemäßen Überwachungseinrichtung. Eine gattungsgemäße Überwachungseinrichtung nach dem Stand der Technik ist in Fig. 4 dargestellt.

Die Überwachungseinrichtung dient zum Durchführen einer analytischen Messung an einer in einem **Reaktionsbehälter 1** erzeugten Reaktionsflüssigkeit in einem **Spektrometer 2,** insbesondere zur Kontrolle einer chemischen Reaktion mittels MR-Spektroskopie.

Die Überwachungseinrichtung weist folgende Baugruppen auf:
eine im Spektrometer 2 angeordnete **Überwachungszelle 3** zur Aufnahme der im Spektrometer 2 zu vermessenden Reaktionsflüssigkeit sowie zu deren Rücktransport zum Reaktionsbehälter 1;
eine Verteilereinrichtung zur Verteilung von Reaktionsflüssigkeit zwischen der Überwachungszelle 3 und dem Reaktionsbehälter 1, in welche mindestens zwei Leitungen 4i', 4o' zur **Zuführung 4i'** von Reaktionsflüssigkeit vom Reaktionsbehälter 1 zur Verteilereinrichtung und zu deren **Rückführung 4o'** von der Verteilereinrichtung zum Reaktionsbehälter 1 sowie mindestens zwei weitere Leitungen 4i", 4o" zur **Zuführung 4i"** von Reaktionsflüssigkeit von der Verteilereinrichtung zur Überwachungszelle 3 und zu deren **Rückführung 4o"** von der Überwachungszelle 3 zur Verteilereinrichtung münden, wobei die Verteilereinrichtung eine **Verteiler-Vorrichtung 5** zur Verteilung von Reaktionsflüssigkeit auf die mindestens vier in die Verteilereinrichtung mündenden Zuführ- und Rückführ-Leitungen 4i', 4o', 4i", 4o" umfasst.

Die erfindungsgemäße Überwachungseinrichtung ist dadurch gekennzeichnet, dass die Verteilereinrichtung einen **Verteiler-Behälter 60** aufweist ,in welchem die Verteiler-Vorrichtung 5 sowie **eine elektrisch ansteuerbare Pumpeinrichtung 61; 62a, 62b** zum Pumpen von Reaktionsflüssigkeit angeordnet sind, dass die Verteiler-Vorrichtung 5 eine **elektrisch ansteuerbare Ventileinrichtung 50** zur Verteilung von Reaktionsflüssigkeit auf die mindestens vier in den Verteiler-Behälter 60 mündenden Zuführ- und Rückführ-Leitungen 4i', 4o', 4i", 4o" umfasst, und dass eine **Steuer- und Regelvorrichtung 70** zur elektrischen Ansteuerung der Pumpeinrichtung 61; 62a, 62b sowie zur elektrischen Ansteuerung der Ventileinrichtung 50 vorhanden ist.

Die -elektrisch ansteuerbare- Ventileinrichtung 50 kann sowohl ein elektrisch als auch ein pneumatisch angetriebenes Ventil umfassen. Die Positions-Ansteuerung bleibt aber bei beiden Ventilarten elektrisch. Im letzteren Fall wird über ein elektrisch angesteuertes Ventil das Steuer-Druckgas entsprechend der gewünschten Position zum Ventil geleitet.

Die mit Reaktionsflüssigkeit benetzten Teile der Pumpeinrichtung 61; 62a, 62b und der Ventileinrichtung 50 sowie der gesamte Flüssigkeitspfad der Reaktionsflüssigkeit werden in der Regel aus chemisch inerten Materialien aufgebaut sein, insbesondere Glas, PTFE (=Polytetrafluorethylen), PCTFE (=Polychlortrifluorethylen), ETFE (=Ethylentetrafluorethylen).

Im Strömungspfad der Rückführ-Leitung 4o' für Reaktionsflüssigkeit von der Verteilereinrichtung zum Reaktionsbehälter 1 ist am Ausgang aus dem Verteiler-Behälter 60 zur Absicherung gegen schädlichen übermäßigen Druckaufbau ein **erstes Überdruckventil V1** eingebaut. Zusätzlich ist in der Zuführ-Leitung 4i"von der Verteilereinrichtung zur Überwachungszelle 3 ein **weiteres Überdruckventil V2** vorgesehen.

Bei der erfindungsgemäßen Überwachungseinrichtung kann -wie in den Figuren 1a bis 3 dargestellt- die elektrisch ansteuerbare Ventileinrichtung 50 zur Verteilung von Reaktionsflüssigkeit ein umschaltbares Vier-Wege-Ventil umfassen, welches in einer ersten Betriebsstellung *("On flow"-Position)* die Zuführ-Leitung 4i' vom Reaktionsbehälter 1 zum Verteiler-Behälter 60 mit der Zuführ-Leitung 4i" vom Verteiler-Behälter 60 zur Überwachungszelle 3 sowie die Rückführ-Leitung 4o" von der Überwachungszelle 3 zum Verteiler-Behälter 60 mit der Rückführ-Leitung 4o' vom Verteiler-Behälter 60 zum Reaktionsbehälter 1 verbindet, und welches in einer zweiten Betriebsstellung *("Stopped flow"-Position)* die Zuführ-Leitung 4i' vom Reaktionsbehälter 1 zum Verteiler-Behälter 60 mit der Rückführ-Leitung 4o' vom Verteiler-Behälter 60 zum Reaktionsbehälter 1 sowie die Zuführ-Leitung 4i" vom Verteiler-Behälter 60 zur Überwachungszelle 3 mit der Rückführ-Leitung 4o" von der Überwachungszelle 3 zum Verteiler-Behälter 60 verbindet.

Bei der in den Figuren 1a *("On-Flow"-Position)* sowie 1b *("Stopped-Flow"-Position*) gezeigten besonders einfachen Ausführungsform der erfindungsgemäßen Überwachungseinrichtung umfasst die elektrisch ansteuerbare Pumpeinrichtung zum Pumpen von Reaktionsflüssigkeit nur eine *einzige* Pumpe 61.

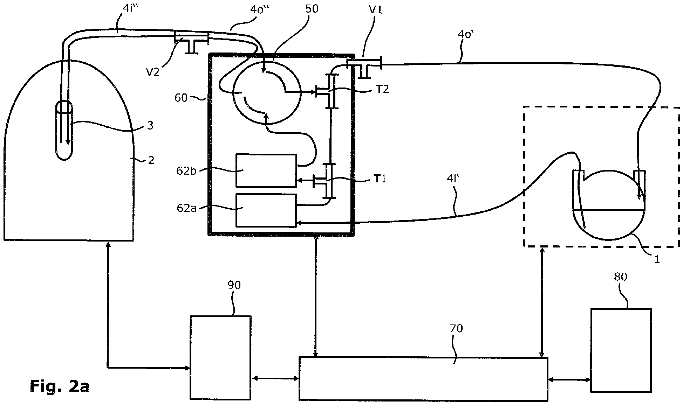

Bei der in den Figuren 2a ("On-Flow"-Position) sowie 2b ("Stopp-Flow"-Position) gezeigten komfortableren Ausführungsform der erfindungsgemäßen Überwachungseinrichtung umfasst die elektrisch ansteuerbare Pumpeinrichtung zum Pumpen von Reaktionsflüssigkeit eine Transportpfad-Pumpe 62a, welche Reaktionsflüssigkeit aus der Zuführ-Leitung 4i' vom Reaktionsbehälter 1 zum Verteiler-Behälter 60 zur Rückführ-Leitung 4o' vom Verteiler-Behälter 60 zum Reaktionsbehälter 1 pumpt, sowie zusätzlich eine Messpfad-Pumpe 62b, welche zumindest einen Teilstrom der von der Transportpfad-Pumpe 62a geförderten Reaktionsflüssigkeit in die Ventileinrichtung 50 zur Verteilung von Reaktionsflüssigkeit auf die mindestens vier in den Verteiler-Behälter 60 mündenden Zuführ- und Rückführ-Leitungen 4i', 4o', 4i", 4o" fördert.

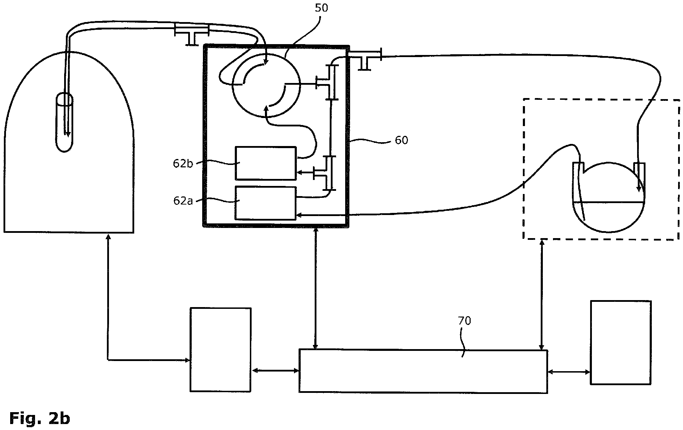

In dieser Ausführungsform kann -wie für die Weiterbildung gemäß den Figuren 2a und 2b gezeigt- im Strömungspfad der geförderten Reaktionsflüssigkeit nach der Transportpfad-Pumpe 62a ein erstes Verteilerstück, insbesondere ein **erstes T-Stück T1,** angeordnet sein, welches einen Teilstrom der von der Transportpfad-Pumpe 62a geförderten Reaktionsflüssigkeit zur Messpfad-Pumpe 62b und einen weiteren Teilstrom zur Rückführ-Leitung 4o' vom Verteiler-Behälter 60 zum Reaktionsbehälter 1 umleitet, sowie im Strömungspfad vor der Rückführ-Leitung 4o' vom Verteiler-Behälter 60 zum Reaktionsbehälter 1 ein weiteres Verteilerstück, insbesondere ein **weiteres T-Stück (T2),** welches den Teilstrom der von der Transportpfad-Pumpe 62a zur Rückführ-Leitung 4o' vom Verteiler-Behälter 60 zum Reaktionsbehälter 1 geförderten Reaktionsflüssigkeit sowie einen Teilstrom von aus der Ventileinrichtung 50 austretenden Reaktionsflüssigkeit zusammenfasst und zur Rückführ-Leitung 4o' vom Verteiler-Behälter 60 zum Reaktionsbehälter 1 umleitet.

Bei allen in der Zeichnung dargestellten Ausführungsformen der erfindungsgemäßen Überwachungseinrichtung ist der Verteiler-Behälter 60 von einem Gehäuse umgeben ist, welches thermisch isolierend aufgebaut ist. Zudem ist eine Thermostat-Einrichtung 80 vorhanden, mittels welcher der gesamte Flusspfad der geförderten Reaktionsflüssigkeit vom Reaktionsbehälter 1 über den Verteiler-Behälter 60 zur Überwachungszelle 3 und zurück einer Temperaturkontrolle, insbesondere einer aktiven Temperaturregelung, unterzogen werden kann, wobei die Steuer- und Regelvorrichtung 70 zur elektrischen Ansteuerung der Pumpeinrichtung 61; 62a, 62b sowie zur elektrischen Ansteuerung der Ventileinrichtung 50 derart ausgestaltet ist, dass sie eine Temperatursteuerung der **Thermostat-Einrichtung 80** in Abhängigkeit vom Reaktionsverlauf im Reaktionsbehälter 1 ermöglicht.

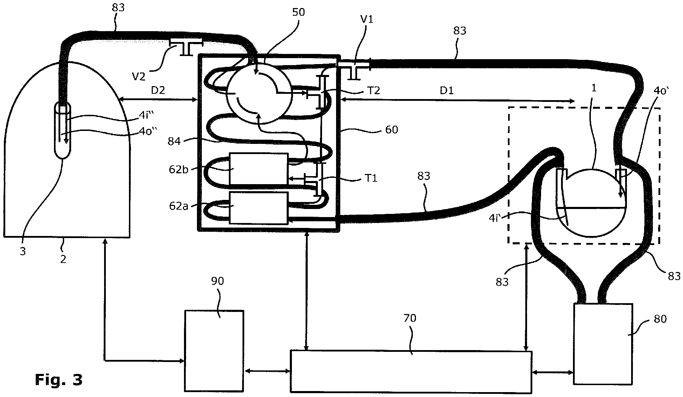

Wie in Fig. 3 (durch entsprechend dicke Linien) angedeutet, sind die Zuführ- und Rückführ-Leitungen 4i', 4o', 4i", 4o" für Reaktionsflüssigkeit auf dem gesamten Flusspfad -zumindest außerhalb des ja ohnehin selbst schon isolierten Verteiler-Behälters 60- von einer **thermischen Isolation 83** umgeben.

Der Thermostaten-Kreislauf und dessen aktive Temperaturregelung innerhalb der thermischen Isolation 83, erstreckt sich nicht nur auf die Leitungen 4i', 4o', 4i" und 4o", sondern auch auf eine **Temperaturübertragungseinrichtung 84** in dem thermisch isolierten Verteiler-Behälter 60. Vorzugsweise ist diese Temperaturübertragungseinrichtung 84 eine Einbindung in den Thermostaten-Kreislauf mit einem Rohr, welches zur Temperaturabgabe geeignet ist (Kupfer, Aluminium, etc...). Alternativ kann diese Aufgabe aber auch etwa von einem elektrisches Peltier-Element erledigt werden.

Die Pumpeinrichtung 61; 62a, 62b und die Ventileinrichtung 50 sowie der gesamte Flusspfad der Reaktionsflüssigkeit sind aus Materialien aufgebaut, die in einem Betriebs-Temperaturbereich von -50°C bis +150°C, vorzugsweise von -20°C bis +100°C, einsetzbar sind. Das System kann also bei Temperaturen von -40°C bis +120°C, insbesondere von -10°C bis + 60°C, verwendet werden.
Die Steuer- und Regelvorrichtung 70 zur elektrischen Ansteuerung der Pumpeinrichtung 61; 62a, 62b sowie zur elektrischen Ansteuerung der Ventileinrichtung 50 ist derart ausgestaltet ist, dass sie eine unabhängige Fluss- und Volumensteuerung, insbesondere eine unabhängige Ansteuerung der Transportpfad-Pumpe 62a und der Messpfad-Pumpe 62b, sowie -zusätzlich oder alternativ- eine Zeit-gesteuerte und/oder eine Volumen-gesteuerte Regelung der Ventileinrichtung 50 und/oder der Pumpeinrichtung 61; 62a, 62b in Abhängigkeit vom Reaktionsverlauf im Reaktionsbehälter 1 ermöglicht.

im Flusspfad der geförderten Reaktionsflüssigkeit, vorzugsweise an verschiedenen, räumlich getrennten Orten sind -in der vorliegenden Zeichnung nicht eigens dargestellte- Sensoren zur Detektion der aktuellen Temperatur und/oder des aktuellen Druckes und/oder des aktuellen pH-Werts und/oder der aktuellen Strömungsgeschwindigkeit der Reaktionsflüssigkeit angeordnet, die mit der Steuer- und Regelvorrichtung 70 zur elektrischen Ansteuerung der Pumpeinrichtung 61; 62a, 62b sowie zur elektrischen Ansteuerung der Ventileinrichtung 50 verbunden sind. Die Steuer- und Regelvorrichtung 70 ist derart ausgestaltet, dass sie eine Temperatur-gesteuerte und/oder eine Druck-gesteuerte und/oder eine pH-Wert-gesteuerte und/oder eine Strömungsgeschwindigkeitsabhängige Regelung der Ventileinrichtung 50 und/oder der Pumpeinrichtung 61; 62a, 62b in Abhängigkeit vom Reaktionsverlauf im Reaktionsbehälter 1 ermöglicht.

Die Steuer- und Regelvorrichtung 70 kommuniziert mit einem **Rechner 90** und kann durch geeignete Softwareinteraktionen den Start bzw. den Stopp von NMR Messungen veranlassen. Über Rückmeldung der NMR Software können gegebenenfalls Reaktionsbedingungen im Reaktor 1 verändert/angepasst werden und eine neue NMR-Messung kann unter den neuen geänderten Bedingungen getriggert werden.

In Fig. 4 schließlich ist schematisiert die aus dem Stand der Technik bekannte Überwachungseinrichtung mit NMR-Durchflusszelle gezeigt, wie sie oben ausführlich diskutiert ist und von der Anmelderin als kommerzielles Produkt *"InsightMR Flow Unit"* angeboten wird.

Im Gegensatz zur Überwachungseinrichtung nach der vorliegenden Erfindung, welche obligatorisch eine *elektrisch ansteuerbare* Ventileinrichtung 50 zur Verteilung von Reaktionsflüssigkeit vorschreibt, ist hier lediglich ein simples Handventil vorgesehen, welches keineswegs elektrisch ansteuerbar ist, sondern zur Betätigung stets einer Bedienungsperson bedarf.

Die ebenfalls für die erfindungsgemäße Überwachungseinrichtung zwingend vorgeschriebene Steuer- und Regelvorrichtung 70 fehlt gänzlich.

Eine **Pumpe 6** zur Förderung von zu vermessender Reaktionsflüssigkeit ist bei diesem System nach dem Stand der Technik außerhalb eines Verteiler-Behälters 60 -den es hier ja auch gar nicht gibt- in der Umgebung des Reaktionsbehälters 1 angeordnet.

Außerdem ist beim Stand der Technik zwar ein sogenannter **Chiller 8** vorgesehen, mit welchem der Flusspfad der Reaktionsflüssigkeit auf einem Abschnitt zwischen der Verteiler-Vorrichtung 5 und dem Spektrometer 2 temperiert werden kann, keinesfalls aber auf dem gesamten Strömungspfad.

Zwar wird auch beim System nach dem Stand der Technik das Spektrometer 2 über einen **Computer 9** (in der Regel einen PC) mittels geeigneter Software (hier: NMR-Software) angesteuert. Bei der erfindungsgemäßen Überwachungseinrichtung erfolgt die Spektrometer-Ansteuerung jedoch über den Rechner 90, welcher seinerseits von der Steuer- und Regelvorrichtung 70 kontrolliert wird, so dass vielfältige Möglichkeiten der -auch automatisierten-Einflussnahme auf das Spektrometer 2 in Abhängigkeit von der Steuer- und Regelvorrichtung 70 zugeführten aktuellen Messdaten aus den oben beschriebenen Sonden/Detektoren eröffnet werden.

Schließlich erkennt man in den Figuren 1a bis 3 auch, dass der Verteiler-Behälter 60 räumlicher näher zur Überwachungszelle 3 als zum Reaktionsbehälter 1 angeordnet ist, wobei insbesondere die **Distanz D1** zwischen Verteiler-Behälter 60 und Reaktionsbehälter 1 in der Praxis doppelt, vorzugsweise dreimal, insbesondere sechsmal, so groß sein kann wie die **Distanz D2** zwischen Verteiler-Behälter 60 und Überwachungszelle 3. Im Gegensatz dazu ist dieses Distanzverhältnis beim Stand der Technik genau umgekehrt, wie man etwa der Figur 4 entnehmen kann.

## Patentansprüche

1. Überwachungseinrichtung zum Durchführen einer analytischen Messung an einer in einem Reaktionsbehälter (1) erzeugten Reaktionsflüssigkeit in einem Spektrometer (2), wobei die Überwachungseinrichtung folgende Baugruppen aufweist:
eine im Spektrometer (2) anzuordnende Überwachungszelle (3) zur Aufnahme der im Spektrometer (2) zu vermessenden Reaktionsflüssigkeit sowie zu deren Rücktransport zum Reaktionsbehälter (1);
eine Verteilereinrichtung zur Verteilung von Reaktionsflüssigkeit zwischen der Überwachungszelle (3) und dem Reaktionsbehälter (1), in welche mindestens zwei Leitungen (4i', 4o') zur Zuführung (4i') von Reaktionsflüssigkeit vom Reaktionsbehälter (1) zur Verteilereinrichtung und zu deren Rückführung (4o') von der Verteilereinrichtung zum Reaktionsbehälter (1) sowie mindestens zwei weitere Leitungen (4i", 4o") zur Zuführung (4i") von Reaktionsflüssigkeit von der Verteilereinrichtung zur Überwachungszelle (3) und zu deren Rückführung (4o") von der Überwachungszelle (3) zur Verteilereinrichtung münden, wobei die Verteilereinrichtung eine Verteiler-Vorrichtung (5) zur Verteilung von Reaktionsflüssigkeit auf die mindestens vier in die Verteilereinrichtung mündenden Zuführ- und Rückführ-Leitungen (4i', 4o', 4i", 4o") umfasst,
**dadurch gekennzeichnet,**
**dass** die Verteilereinrichtung einen Verteiler-Behälter (60) aufweist ,in welchem die Verteiler-Vorrichtung (5) sowie eine elektrisch ansteuerbare Pumpeinrichtung (61; 62a, 62b) zum Pumpen von Reaktionsflüssigkeit angeordnet sind,
**dass** die Verteiler-Vorrichtung (5) eine elektrisch ansteuerbare Ventileinrichtung (50) zur Verteilung von Reaktionsflüssigkeit auf die mindestens vier in den Verteiler-Behälter (60) mündenden Zuführ- und Rückführ-Leitungen (4i', 4o', 4i", 4o") umfasst,
**dass** eine Steuer- und Regelvorrichtung (70) zur elektrischen Ansteuerung der Pumpeinrichtung (61; 62a, 62b) sowie zur elektrischen Ansteuerung der Ventileinrichtung (50) vorhanden ist
und **dass** die elektrisch ansteuerbare Ventileinrichtung (50) zur Verteilung von Reaktionsflüssigkeit ein umschaltbares Vier-Wege-Ventil umfasst,
welches in einer ersten Betriebsstellung ("on flow") die Zuführ-Leitung (4i') vom Reaktionsbehälter (1) zum Verteiler-Behälter (60) -direkt oder indirekt- mit der Zuführ-Leitung (4i") vom Verteiler-Behälter (60) zur Überwachungszelle (3) sowie die Rückführ-Leitung (4o") von der Überwachungszelle (3) zum Verteiler-Behälter (60) -direkt oder indirektmit der Rückführ-Leitung (4o') vom Verteiler-Behälter (60) zum Reaktionsbehälter (1) verbinden kann,
und welches in einer zweiten Betriebsstellung ("stopped flow") die Zuführ-Leitung (4i') vom Reaktionsbehälter (1) zum Verteiler-Behälter (60) -direkt oder indirekt- mit der Rückführ-Leitung (4o') vom Verteiler-Behälter (60) zum Reaktionsbehälter (1) sowie die Zuführ-Leitung (4i") vom Verteiler-Behälter (60) zur Überwachungszelle (3) -direkt oder indirekt- mit der Rückführ-Leitung (4o") von der Überwachungszelle (3) zum Verteiler-Behälter (60) verbinden kann.

2. Überwachungseinrichtung nach Anspruch 1, **dadurch gekennzeichnet, dass** die elektrisch ansteuerbare Pumpeinrichtung zum Pumpen von Reaktionsflüssigkeit nur eine einzige Pumpe (61) umfasst.

3. Überwachungseinrichtung nach Anspruch 1, **dadurch gekennzeichnet, dass** die elektrisch ansteuerbare Pumpeinrichtung zum Pumpen von Reaktionsflüssigkeit eine Transportpfad-Pumpe (62a) umfasst, welche Reaktionsflüssigkeit aus der Zuführ-Leitung (4i') vom Reaktionsbehälter (1) zum Verteiler-Behälter (60) zur Rückführ-Leitung (4o') vom Verteiler-Behälter (60) zum Reaktionsbehälter (1) pumpen kann,
und dass die Pumpeinrichtung zusätzlich eine Messpfad-Pumpe (62b) umfasst, welche zumindest einen Teilstrom der von der Transportpfad-Pumpe (62a) geförderten Reaktionsflüssigkeit in die Ventileinrichtung (50) zur Verteilung von Reaktionsflüssigkeit auf die mindestens vier in den Verteiler-Behälter (60) mündenden Zuführ- und Rückführ-Leitungen (4i', 4o', 4i", 4o") pumpen kann.

4. Uberwachungseinrichtung nach Anspruch 3, **dadurch gekennzeichnet, dass** im Strömungspfad der geförderten Reaktionsflüssigkeit nach der Transportpfad-Pumpe (62a) ein erstes Verteilerstück, insbesondere ein erstes T-Stück (T1), angeordnet ist, welches einen Teilstrom der von der Transportpfad-Pumpe (62a) geförderten Reaktionsflüssigkeit zur Messpfad-Pumpe (62b) und einen weiteren Teilstrom zur Rückführ-Leitung (4o') vom Verteiler-Behälter (60) zum Reaktionsbehälter (1) umleitet,
und dass im Strömungspfad der geförderten Reaktionsflüssigkeit vor der Rückführ-Leitung (4o') vom Verteiler-Behälter (60) zum Reaktionsbehälter (1) ein weiteres Verteilerstück, insbesondere ein weiteres T-Stück (T2), angeordnet ist, welches den Teilstrom der von der Transportpfad-Pumpe (62a) zur Rückführ-Leitung (4o') vom Verteiler-Behälter (60) zum Reaktionsbehälter (1) geförderten Reaktionsflüssigkeit sowie einen Teilstrom von aus der Ventileinrichtung (50) austretenden Reaktionsflüssigkeit zusammenfasst und zur Rückführ-Leitung (4o') vom Verteiler-Behälter (60) zum Reaktionsbehälter (1) umleitet.

5. Uberwachungseinrichtung nach einem der vorhergehenden Ansprüche, **dadurch gekennzeichnet, dass** die mit Reaktionsflüssigkeit benetzten Teile der Pumpeinrichtung (61; 62a, 62b) und der Ventileinrichtung (50) sowie der gesamte Flüssigkeitspfad der Reaktionsflüssigkeit aus chemisch inerten Materialien aufgebaut sind, insbesondere Glas, PTFE (=Polytetrafluorethylen), PCTFE (=Polychlortrifluorethylen), ETFE (=Ethylentetrafluorethylen).

6. Überwachungseinrichtung nach einem der vorhergehenden Ansprüche, **dadurch gekennzeichnet, dass** die Pumpeinrichtung (61; 62a, 62b) und die Ventileinrichtung (50) sowie der gesamte Flüssigkeitspfad der Reaktionsflüssigkeit aus Materialien aufgebaut sind, die in einem Betriebs-Temperaturbereich von -50°C bis +150°C, vorzugsweise von -20°C bis +100°C, einsetzbar sind.

7. Überwachungseinrichtung nach einem der Ansprüche 2 bis 6, **dadurch gekennzeichnet, dass** zumindest eine Pumpe der elektrisch ansteuerbaren Pumpeinrichtung zum Pumpen von Reaktionsflüssigkeit, vorzugsweise die Transportpfad-Pumpe (62a), derart ausgelegt ist, dass sie mit einer Flussrate zwischen 10ml/min und 1000ml/min, vorzugsweise mehr als 20ml/min, betrieben werden kann.

8. Überwachungseinrichtung nach einem der Ansprüche 2 bis 7, **dadurch gekennzeichnet, dass** zumindest eine Pumpe der elektrisch ansteuerbaren Pumpeinrichtung zum Pumpen von Reaktionsflüssigkeit, vorzugsweise die Messpfad-Pumpe (62b), derart ausgelegt ist, dass sie mit einer Flussrate zwischen 0,1ml und 10ml, vorzugsweise ≤1ml/min, betrieben werden kann.

9. Überwachungseinrichtung nach einem der vorhergehenden Ansprüche, **dadurch gekennzeichnet, dass** die Steuer- und Regelvorrichtung (70) zur elektrischen Ansteuerung der Pumpeinrichtung (61; 62a, 62b) sowie zur elektrischen Ansteuerung der Ventileinrichtung (50) derart ausgestaltet ist, dass sie eine unabhängige Steuerung der Flussrate und des geförderten Volumens von Reaktionsflüssigkeit, insbesondere eine unabhängige Ansteuerung der Transportpfad-Pumpe (62a) und der Messpfad-Pumpe (62b), in Abhängigkeit vom Reaktionsverlauf im Reaktionsbehälter (1) ermöglicht.

10. Überwachungseinrichtung nach einem der vorhergehenden Ansprüche, **dadurch gekennzeichnet, dass** die Steuer- und Regelvorrichtung (70) zur elektrischen Ansteuerung der Pumpeinrichtung (61; 62a, 62b) sowie zur elektrischen Ansteuerung der Ventileinrichtung (50) derart ausgestaltet ist, dass sie eine Zeit-gesteuerte und/oder eine Volumen-gesteuerte Regelung der Ventileinrichtung (50) und/oder der Pumpeinrichtung (61; 62a, 62b) in Abhängigkeit vom Reaktionsverlauf im Reaktionsbehälter (1) ermöglicht.

11. Überwachungseinrichtung nach einem der vorhergehenden Ansprüche, **dadurch gekennzeichnet, dass** im Flusspfad der geförderten Reaktionsflüssigkeit, vorzugsweise an verschiedenen, räumlich getrennten Orten, Sensoren zur Detektion der aktuellen Temperatur und/oder des aktuellen Druckes und/oder des aktuellen pH-Werts und/oder der aktuellen Strömungsgeschwindigkeit der Reaktionsflüssigkeit angeordnet sind, die mit der Steuer- und Regelvorrichtung (70) zur elektrischen Ansteuerung der Pumpeinrichtung (61; 62a, 62b) sowie zur elektrischen Ansteuerung der Ventileinrichtung (50) verbunden sind, und dass die Steuer- und Regelvorrichtung (70) derart ausgestaltet ist, dass sie eine Temperatur-gesteuerte und/oder eine Druck-gesteuerte und/oder eine pH-Wert-gesteuerte und/oder eine Strömungsgeschwindigkeitsabhängige Regelung der Ventileinrichtung (50) und/oder der Pumpeinrichtung (61; 62a, 62b) in Abhängigkeit vom Reaktionsverlauf im Reaktionsbehälter (1) ermöglicht.

12. Überwachungseinrichtung nach einem der vorhergehenden Ansprüche, **dadurch gekennzeichnet, dass** der Verteiler-Behälter (60) von einem Gehäuse umgeben ist, welches thermisch isolierend aufgebaut ist.

13. Uberwachungseinrichtung nach einem der vorhergehenden Ansprüche, **dadurch gekennzeichnet, dass** eine Thermostat-Einrichtung (80) vorhanden ist, mittels welcher der gesamte Flusspfad der geförderten Reaktionsflüssigkeit vom Reaktionsbehälter (1) über den Verteiler-Behälter (60) zur Überwachungszelle (3) und zurück einer Temperaturkontrolle, insbesondere einer aktiven Temperaturregelung, unterzogen werden kann, und dass die Steuer- und Regelvorrichtung (70) zur elektrischen Ansteuerung der Pumpeinrichtung (61; 62a, 62b) sowie zur elektrischen Ansteuerung der Ventileinrichtung (50) vorzugsweise derart ausgestaltet ist, dass sie eine Temperatursteuerung der Thermostat-Einrichtung (80) in Abhängigkeit vom Reaktionsverlauf im Reaktionsbehälter (1) ermöglicht.

14. Uberwachungseinrichtung nach einem der vorhergehenden Ansprüche, **dadurch gekennzeichnet, dass** der Verteiler-Behälter (60) räumlicher näher zur Überwachungszelle (3) als zum Reaktionsbehälter (1) angeordnet ist, wobei insbesondere die Distanz (D1) zwischen Verteiler-Behälter (60) und Reaktionsbehälter (1) doppelt, vorzugsweise dreimal, insbesondere sechsmal, so groß ist wie die Distanz (D2) zwischen Verteiler-Behälter (60) und Überwachungszelle (3).

## Claims

1. A monitoring device for conducting an analytical measurement of a reaction fluid produced in a reaction vessel (1) in a spectrometer (2), wherein the monitoring device comprises the following assemblies:
a monitoring cell (3) to be arranged in the spectrometer (2) for receiving the reaction fluid to be measured in the spectrometer (2) and transporting it back to the reaction vessel (1);
a distribution device for distributing the reaction fluid between the monitoring cell (3) and the reaction vessel (1), in which at least two lines (4i', 4o') for the supply (4i') of reaction fluid from the reaction vessel (1) to the distribution device and for the return (4o') thereof from the distribution device to the reaction vessel (1) and at least two further lines (4i", 4o") for the supply (4i") of reaction fluid from the distribution device to the monitoring cell (3) and for the return (4o") thereof from the monitoring cell (3) open into the distribution device, wherein the distribution device comprises a distribution device (5) for distributing reaction fluid to the at least four supply and return lines (4i', 4o', 4i", 4o'') opening into the distribution device,
**characterized in that**
the distribution device comprises a distribution vessel (60) in which the distribution device (5) and an electrically controllable pump device (61; 62a, 62b) for pumping of the reaction fluid are arranged,
that the distribution device (5) comprises an electrically controllable valve device (50) for distributing the reaction fluid to the at least four supply and return lines (4i', 4o', 4i", 4o") opening into the distribution vessel (60),
that a control and regulating device (70) is present for electrical control of the pump device (61; 62a, 62b) and for electrical control of the valve device (50), and that the electrically controllable valve device (50) for distributing the reaction fluid comprises a switchable four-way valve,
which, in a first operating position ("on flow"), can connect the supply line (4i') from the reaction vessel (1) to the distribution vessel (60) -directly or indirectly - with the supply line (4i") from the distribution vessel (60) to the monitoring cell (3) and the return line (4o") from the monitoring cell (3) to the distribution vessel (60) - directly or indirectly - with the return line (4o') from the distribution vessel (60) to the reaction vessel (1),
and which, in a second operating position ("stopped flow"), can connect the supply line (4i') from the reaction vessel (1) to the distribution vessel (60) - directly or indirectly - with the return line (4o') from the distribution vessel (60) to the reaction vessel (1) and the supply line (4i") from the distribution vessel (60) to the monitoring cell (3) - directly or indirectly - with the return line (4o") from the monitoring cell (3) to the distribution vessel (60) .

2. The monitoring device as claimed in claim 1, **characterized in that** the electrically controllable pump device for pumping of the reaction fluid comprises only a single pump (61).

3. The monitoring device as claimed in claim 1, **characterized in that** the electrically controllable pump device for pumping of the reaction fluid comprises a transportation path pump (62a), which can pump reaction fluid from the supply line (4i') from the reaction vessel (1) to the distribution vessel (60) to the return line (4o') from the distribution vessel (60) to the reaction vessel (1),
and the pump device additionally comprises a measurement path pump (62b), which can pump at least one partial stream of the reaction fluid conveyed by the transportation path pump (62a) into the valve device (50) for distributing reaction fluid to the at least four supply and return lines (4i', 4o', 4i", 4o") opening into the distribution vessel (60).

4. The monitoring device as claimed in claim 3, **characterized in that** in the flow path of the conveyed reaction fluid downstream of the transportation path pump (62a), a first distribution piece, more particularly a first T piece (T1), is arranged, which diverts a partial stream of the reaction fluid conveyed by the transportation path pump (62a) to the measurement path pump (62b) and a further partial stream to the return line (4o') from the distribution vessel (60) to the reaction vessel (1),
and that in the flow path of the conveyed reaction fluid, a further distribution piece, more particularly a further T piece (T2), is arranged upstream of the return line (4o') from the distribution vessel (60) to the reaction vessel (1), which combines the partial stream of the reaction fluid conveyed by the transportation path pump (62a) to the return line (4o') from the distribution vessel (60) to the reaction vessel (1) and a partial stream of reaction fluid exiting the valve device (50) and diverts said combined stream to the return line (4o') from the distribution vessel (60) to the reaction vessel (1).

5. The monitoring device as claimed in one of the preceding claims, **characterized in that** the parts of the pump device (61; 62a, 62b) and the valve device (50) moistened with reaction fluid and the entire fluid path of the reaction fluid are composed of chemically inert materials, more particularly glass, PTFE (polytetrafluoroethylene), PCTFE (polychlorotrifluoroethylene), ETFE (ethylene tetrafluoroethylene).

6. The monitoring device as claimed in one of the preceding claims, **characterized in that** the pump device (61; 62a, 62b), the valve device (50), and the entire fluid path of the reaction fluid are composed of materials that are usable in an operating temperature range of -50°C to +150°C, and preferably -20°C to +100°C.

7. The monitoring device as claimed in one of claims 2 through 6, **characterized in that** at least one pump of the electrically controllable pump device for pumping of the reaction fluid, preferably the transportation path pump (62a), is configured such that it can be operated at a flow rate of between 10 ml/min and 1,000 ml/min, and preferably more than 20 ml/min.

8. The monitoring device as claimed in one of claims 2 through 7, **characterized in that** at least one pump of the electrically controllable pump device for pumping of the reaction fluid, preferably the measurement path pump (62b), is configured such that it can be operated at a flow rate of between 0.1 ml and 10 ml, and preferably ≤ 1 ml/min.

9. The monitoring device as claimed in one of the preceding claims, **characterized in that** the control and regulating device (70) for electrical control of the pump device (61; 62a, 62b) and for electrical control of the valve device (50) is configured such that it allows independent flow and conveyed volume control, more particularly independent control of the transportation path pump (62a) and the measurement path pump (62b), depending on the course of the reaction in the reaction vessel (1).

10. The monitoring device as claimed in one of the preceding claims, **characterized in that** the control and regulating device (70) for electrical control of the pump device (61; 62a, 62b) and for electrical control of the valve device (50) is configured such that it allows time-controlled and/or volume-controlled regulation of the valve device (50) and/or the pump device (61; 62a, 62b), depending on the course of the reaction in the reaction vessel (1).

11. The monitoring device as claimed in one of the preceding claims, **characterized in that** in the flow path of the conveyed reaction fluid, preferably at different, spatially separate sites, sensors are arranged for detection of the current temperature and/or the current pressure and/or the current pH value and/or the current flow rate of the reaction fluid that are connected with the control and regulating device (70) for electrical control of the pump device (61;
62a, 62b) and for electrical control of the valve device (50), and wherein the control and regulating device (70) is configured such that it allows temperature-controlled and/or pressure-controlled and/or pH-value-controlled and/or flow-rate-dependent regulation of the valve device (50) and/or the pump device (61; 62a, 62b), depending on the course of the reaction in the reaction vessel (1).

12. The monitoring device as claimed in one of the preceding claims, **characterized in that** the distribution vessel (60) is enclosed in a housing that is constructed in a thermally insulating manner.

13. The monitoring device as claimed in one of the preceding claims, **characterized in that** a thermostat device (80) is present by means of which the entire flow path of the conveyed reaction fluid from the reaction vessel (1) via the distribution vessel (60) to the monitoring cell (3) and back can be subjected to temperature control, more particularly active temperature control, and that the control and regulating device (70) for electrical control of the pump device (61; 62a, 62b) and for electrical control of the valve device (50) is preferably configured such that it allows temperature control of the thermostat device (80), depending on the course of the reaction in the reaction vessel (1).

14. The monitoring device as claimed in one of the preceding claims, **characterized in that** the distribution vessel (60) is spatially arranged closer to the monitoring cell (3) than to the reaction vessel (1) wherein more particularly, the distance (D1) between the distribution vessel (60) and the reaction vessel (1) is twice, preferably three times, and more particularly six times as large as the distance (D2) between the distribution vessel (60) and the monitoring cell (3).

## Revendications

1. Dispositif de surveillance destiné à effectuer une mesure analytique sur un liquide de réaction produit dans un récipient de réaction (1) dans un spectromètre (2), le dispositif de surveillance possédant les sous-ensembles suivants :
une cellule de surveillance (3) à disposer dans le spectromètre (2), servant à l'accueil du liquide de réaction à mesurer dans le spectromètre (2) ainsi qu'à son transport en retour vers le récipient de réaction (1) ;
un dispositif de distribution destiné à distribuer le liquide de réaction entre la cellule de surveillance (3) et le récipient de réaction (1), dans lequel débouchent au moins deux conduites (4i', 4o') destinées à l'acheminement (4i') du liquide de réaction du récipient de réaction (1) au dispositif de distribution et à son retour (4o') du dispositif de distribution vers le récipient de réaction (1) ainsi qu'au moins deux conduites supplémentaires (4i'', 4o'') destinées à l'acheminement (4i'') du liquide de réaction du dispositif de distribution à la cellule de surveillance (3) et à son retour (4o'') de la cellule de surveillance (3) au dispositif de distribution, le dispositif de distribution comportant un arrangement de distribution (5) destiné à distribuer du liquide de réaction sur les au moins quatre conduites d'acheminement et de retour (4i', 4o', 4i'', 4o'') qui débouchent dans le dispositif de distribution,
**caractérisé en ce**
**que** le dispositif de distribution possède un récipient de distribution (60) dans lequel sont disposés l'arrangement de distribution (5) ainsi qu'un dispositif de pompage (61 ; 62a, 62b) commandable électriquement destiné au pompage du liquide de réaction,
**que** l'arrangement de distribution (5) comporte un dispositif à vanne (50) commandable électriquement servant à la distribution du liquide de réaction sur les au moins quatre conduites d'acheminement et de retour (4i', 4o', 4i'', 4o'') qui débouchent dans le récipient de distribution (60),
**qu'**un arrangement de commande et de régulation (70) destiné à commander électriquement le dispositif de pompage (61 ; 62a, 62b) ainsi qu'à commander électriquement le dispositif à vanne (50) est présent et que le dispositif à vanne (50) commandable électriquement, pour la distribution du liquide de réaction, comporte une vanne à quatre voies permutable, laquelle, dans une première position de service ("on flow" (« écoulement activé »)), peut relier la conduite d'acheminement (4i') du récipient de réaction (1) au récipient de distribution (60) - directement ou indirectement - à la conduite d'acheminement (4i") du récipient de distribution (60) à la cellule de surveillance (3) ainsi que la conduite de retour (4o'') de la cellule de surveillance (3) au récipient de distribution (60) - directement ou indirectement - à la conduite de retour (4o') du récipient de distribution (60) au récipient de réaction (1),
et laquelle, dans une deuxième position de service ("stopped flow" (« écoulement arrêté »)), peut relier la conduite d'acheminement (4i') du récipient de réaction (1) au récipient de distribution (60) - directement ou indirectement - à la conduite de retour (4o') du récipient de distribution (60) au récipient de réaction (1) ainsi que la conduite d'acheminement (4i'') du récipient de distribution (60) à la cellule de surveillance (3) - directement ou indirectement - à la conduite de retour (4o'') de la cellule de surveillance (3) au récipient de distribution (60).

2. Dispositif de surveillance selon la revendication 1, **caractérisé en ce que** le dispositif de pompage commandable électriquement destiné au pompage du liquide de réaction ne comporte qu'une seule pompe (61).

3. Dispositif de surveillance selon la revendication 1, **caractérisé en ce**
**que** le dispositif de pompage commandable électriquement destiné au pompage du liquide de réaction comporte une pompe de trajet de transport (62a), laquelle peut pomper du liquide de réaction hors de la conduite d'acheminement (4i') du récipient de réaction (1) au récipient de distribution (60) vers la conduite de retour (4o') du récipient de distribution (60) au récipient de réaction (1) ,
et **que** le dispositif de pompage comporte en plus une pompe de trajet de mesure (62b), laquelle peut pomper au moins un courant partiel du liquide de réaction transporté par la pompe de trajet de transport (62a) dans le dispositif à vanne (50) servant à la distribution du liquide de réaction sur les au moins quatre conduites d'acheminement et de retour (4i', 4o', 4i'', 4o'') qui débouchent dans le récipient de distribution (60).

4. Dispositif de surveillance selon la revendication 3, **caractérisé en ce**
**que** dans le trajet d'écoulement du liquide de réaction transporté, après la pompe de trajet de transport (62a), est disposée une première pièce de distribution, notamment une première pièce en T (T1), laquelle dévie un courant partiel du liquide de réaction transporté par la pompe de trajet de transport (62a) vers la pompe de trajet de mesure (62b) et un courant partiel supplémentaire vers la conduite de retour (4o') du récipient de distribution (60) au récipient de réaction (1) ,
**que** dans le trajet d'écoulement du liquide de réaction transporté, avant la conduite de retour (4o') du récipient de distribution (60) au récipient de réaction (1), est disposée une pièce de distribution supplémentaire, notamment une deuxième pièce en T (T2), laquelle regroupe le courant partiel du liquide de réaction transporté par la pompe de trajet de transport (62a) vers la conduite de retour (4o') du récipient de distribution (60) au récipient de réaction (1) ainsi qu'un courant partiel du liquide de réaction qui sort du dispositif à vanne (50) et les dévie vers la conduite de retour (4o') du récipient de distribution (60) au récipient de réaction (1).

5. Dispositif de surveillance selon l'une des revendications précédentes, **caractérisé en ce que** les parties du dispositif de pompage (61 ; 62a, 62b) et du dispositif à vanne (50) qui sont mouillées par le liquide de réaction ainsi que la totalité du trajet de liquide du liquide de réaction sont constituées de matériaux chimiquement inertes, notamment de verre, de PTFE (= polytétrafluoroéthylène), de PCTFE (= polychlorotrifluoroéthylène), d'ETFE (= éthylène tétrafluoroéthylène) .

6. Dispositif de surveillance selon l'une des revendications précédentes, **caractérisé en ce que** le dispositif de pompage (61 ; 62a, 62b) et le dispositif à vanne (50) ainsi que la totalité du trajet de liquide du liquide de réaction sont constitués de matériaux qui peuvent être utilisés dans une plage de températures de service de -50 °C à +150 °C, de préférence de -20 °C à +100 °C.

7. Dispositif de surveillance selon l'une des revendications 2 à 6, **caractérisé en ce qu'**au moins une pompe du dispositif de pompage commandable électriquement destiné au pompage du liquide de réaction, de préférence la pompe de trajet de transport (62a), est configurée de telle sorte qu'elle peut fonctionner avec un débit compris entre 10 ml/min et 1000 ml/min, de préférence de plus de 20 ml/min.

8. Dispositif de surveillance selon l'une des revendications 2 à 7, **caractérisé en ce qu'**au moins une pompe du dispositif de pompage commandable électriquement destiné au pompage du liquide de réaction, de préférence la pompe de trajet de mesure (62b), est configurée de telle sorte qu'elle peut fonctionner avec un débit compris entre 0,1 ml et 10 ml, de préférence ≤ 1 ml/min.

9. Dispositif de surveillance selon l'une des revendications précédentes, **caractérisé en ce que** l'arrangement de commande et de régulation (70) destiné à commander électriquement le dispositif de pompage (61 ; 62a, 62b) ainsi qu'à commander électriquement le dispositif à vanne (50) est configuré de telle sorte qu'il rend possible une commande indépendante du débit et du volume transporté du liquide de réaction, notamment une commande indépendante de la pompe de trajet de transport (62a) et de la pompe de trajet de mesure (62b),
en fonction du déroulement de la réaction dans le récipient de réaction (1).

10. Dispositif de surveillance selon l'une des revendications précédentes, **caractérisé en ce que** l'arrangement de commande et de régulation (70) destiné à commander électriquement le dispositif de pompage (61 ; 62a, 62b) ainsi qu'à commander électriquement le dispositif à vanne (50) est configuré de telle sorte qu'il rend possible une régulation commandée dans le temps et/ou commandée par le volume du dispositif à vanne (50) et/ou du dispositif de pompage (61 ; 62a, 62b) en fonction du déroulement de la réaction dans le récipient de réaction (1).

11. Dispositif de surveillance selon l'une des revendications précédentes, **caractérisé en ce que** des capteurs destinés à la détection de la température actuelle et/ou de la pression actuelle et/ou de la valeur pH actuelle et/ou de la vitesse d'écoulement actuelle du liquide de réaction sont disposés dans le trajet d'écoulement du liquide de réaction transporté, de préférence en différents endroits séparés dans l'espace, lesquels sont reliés à l'arrangement de commande et de régulation (70) destiné à commander électriquement le dispositif de pompage (61 ; 62a, 62b) ainsi qu'à commander électriquement le dispositif à vanne (50), et **en ce que** l'arrangement de commande et de régulation (70) est configuré de telle sorte qu'il rend possible une régulation commandée par la température et/ou commandée par la pression et/ou commandée par la valeur pH et/ou dépendante de la vitesse d'écoulement du dispositif à vanne (50) et/ou du dispositif de pompage (61 ; 62a, 62b) en fonction du déroulement de la réaction dans le récipient de réaction (1).

12. Dispositif de surveillance selon l'une des revendications précédentes, **caractérisé en ce que** le récipient de distribution (60) est entouré par un boîtier qui est construit de manière thermiquement isolante.

13. Dispositif de surveillance selon l'une des revendications précédentes, **caractérisé en ce qu'**un dispositif à thermostat (80) est présent, au moyen duquel l'ensemble du trajet d'écoulement du liquide de réaction transporté du récipient de réaction (1) vers la cellule de surveillance (3) par le biais du récipient de distribution (60) et en retour, peut être soumis à un contrôle de la température, notamment une régulation de température active, et **en ce que** l'arrangement de commande et de régulation (70) destiné à commander électriquement le dispositif de pompage (61 ; 62a, 62b) ainsi qu'à commander électriquement le dispositif à vanne (50) est de préférence configuré de telle sorte qu'il rend possible une commande en température du dispositif à thermostat (80) en fonction du déroulement de la réaction dans le récipient de réaction (1).

14. Dispositif de surveillance selon l'une des revendications précédentes, **caractérisé en ce que** le récipient de distribution (60) est disposé plus près dans l'espace de la cellule de surveillance (3) que du récipient de réaction (1), la distance (D1) entre le récipient de distribution (60) et le récipient de réaction (1) étant notamment égale au double de, de préférence au triple de, de préférence à six fois, la distance (D2) entre le récipient de distribution (60) et la cellule de surveillance (3).
